# EUROPEAN PATENT APPLICATION

(11) **EP 3 911 126 A1**
(43) Date of publication of application: **17.11.2021**
(21) Application number: 20174949.6
(22) Date of filing: 15.05.2020
(51) Int. Cl.: H05G 2/00, G03F 7/20, G02F 1/39

(54) **EUV RADIATION SOURCE**

(71) Applicant: Stichting Nederlandse Wetenschappelijk Onderzoek Instituten, 3526 KV Utrecht (NL); Universiteit van Amsterdam, 1012 WX Amsterdam (NL); Stichting VU, 1081 HV Amsterdam (NL); ASML Netherlands B.V., 5500 AH Veldhoven (NL)
(72) Inventor: BEHNKE, Lars Peter, 3527 JP Utrecht (NL)
(74) Representative: ASML Netherlands B.V.

(57) **Abstract**

An EUV radiation source comprising a fuel emitter configured to produce fuel droplets; a laser system configured to illuminate a fuel droplet at a plasma formation region, the laser system comprising: a first laser configured to produce radiation of a first wavelength in a first radiation beam, a second laser configured to produce radiation of a second wavelength in a second radiation beam, and a first parametric amplifier arranged to receive the radiation of the first wavelength and radiation of the second wavelength and generate an amplified radiation beam; and a beam delivery system for delivering the amplified radiation beam to the plasma formation region.

## Description

### FIELD

The present invention relates to an extreme ultraviolet radiation source of a laser-produced plasma type, and related methods. The extreme ultraviolet radiation source may form part of a lithographic system.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a conventional lithographic apparatus (which may use, for example, radiation with a wavelength of 193 nm).

One known type of EUV radiation source directs laser radiation onto fuel droplets. This converts the fuel droplets into EUV radiation emitting plasma. A radiation source of this type may be referred to as a laser-produced plasma (LPP) source. Known LPP sources suffer from poor conversion efficiency. That is, the power of EUV radiation output from the LPP source is a small fraction of the power of laser radiation which is incident upon the fuel droplets.

It may be desirable to provide an EUV radiation source which has a better efficiency than a conventional LPP radiation source, or which overcomes some other disadvantage associated with conventional LPP radiation sources.

### SUMMARY

According to a first aspect of the invention there is provided an EUV radiation source comprising: a fuel emitter configured to produce fuel droplets; a laser system configured to illuminate a fuel droplet at a plasma formation region, the laser system comprising: a first laser configured to produce radiation of a first wavelength in a first radiation beam, a second laser configured to produce radiation of a second wavelength in a second radiation beam, and a first parametric amplifier arranged to receive the radiation of the first wavelength and radiation of the second wavelength and generate an amplified radiation beam; and a beam delivery system configured to deliver the amplified radiation beam to the plasma formation region.

The EUV radiation source may be of a laser produced plasma type. The radiation of the first and/or second wavelength may be pulsed. The amplified radiation beam comprises amplified radiation. The amplified radiation may be pulsed. The first laser may be considered a pump laser to the parametric amplifier. The second laser may be considered a seed laser to the parametric amplifier. Beneficially, a laser system as described herein may improve the conversion efficiency of an EUV radiation source compared to conventional laser systems for EUV radiation sources.

The EUV radiation source may further comprise a profile modulating apparatus configured to provide the radiation of the first and/or second wavelength with a box shaped temporal profile.

Beneficially, using a box shaped temporal profile may increase the conversion efficiency of the parametric amplifier. As such, using a box shaped temporal profile may increase the conversion efficiency of an EUV radiation source and/or increase the dose of EUV radiation generated by an EUV radiation source. A box shaped temporal profile may alternatively be referred to as a top hat profile.

The profile modulating apparatus may be an acousto-optic modulator (AOM) or an electro-optic modulator (EOM). Beneficially, both AOM and EOM may modulate a pulsed radiation beam with a high repetition rate, for example 100 kHz.

The first and/or second laser may comprise the profile modulating apparatus. The profile modulating apparatus may comprise part of the gain medium of the first and/or second laser. The profile modulating apparatus may comprise a Bragg grating of a distributed feedback laser. The profile modulating apparatus may comprise a fiber pumped laser where the pumping radiation is provided with a box shaped temporal profile.

The laser system may further comprise a second parametric amplifier arranged to receive radiation of the first wavelength and radiation of the second wavelength and generate an additional amplified radiation beam, and wherein the beam delivery system is configured to deliver the additional amplified radiation beam to the plasma formation.

The first radiation beam and second radiation beam may be separated into portions and delivered to the first and second parametric amplifiers. By using more than one parametric amplifier, the chance in each parametric amplifier may be reduced. By using more than one parametric amplifier, the total power of amplified radiation (i.e. in the amplified radiation beam and additional amplified radiation beam) is increased. As a result, an increased power of EUV radiation may be generated by the EUV radiation source. Any number of parametric amplifiers may be used, for example five parametric amplifiers. With additional parametric amplifiers, a plurality of additional amplified radiation beams may be generated.

The beam delivery system may comprise optical components configured to collimate the amplified radiation beam and the (one or a plurality of) additional amplified radiation beams. Such optical components may comprise, for example, a prism, a collimating lens, a holographic lens, a modulating apparatus such as an acousto-optic modulator or electro-optic modulator,

The additional amplified radiation beam comprises amplified radiation of the second wavelength. The additional amplified radiation beam may further comprise radiation of the first wavelength, and optionally radiation of a third wavelength. The additional amplified radiation beam may comprise pulsed radiation.

The first radiation beam may comprise pulsed radiation. The laser system may further comprise a pulse modulating apparatus configured to receive the pulsed radiation and direct a first pulse to the first parametric amplifier and a second pulse to the second parametric amplifier; and a beamsplitting apparatus configured to receive the second radiation beam and direct a first portion of the second radiation beam to the first parametric amplifier and a second portion of the second radiation beam to the second parametric amplifier.

By directing a first pulse to a first parametric amplifier and a second pulse to a second parametric amplifier, the chance of damage in each parametric amplifier is reduced. As a result, each parametric amplifier may generate an amplified or additional amplified radiation beam with increased power. As a result, an increased power of EUV radiation may be generated by the EUV radiation source.

The second radiation beam may comprise pulsed radiation.

The pulse modulating apparatus may be configured to direct one or more pulses to additional parametric apparatuses. Alternatively, the laser system may further comprise additional pulse modulating apparatuses.

The second laser may comprise a solid state laser. Beneficially, solid state lasers typically have a low wall plug efficiency. Solid state lasers may provide radiation which is relatively easy to focus with precision, compared to other sources of radiation. The second laser may comprise a fiber based laser, for example a fiber laser or fiber pumped laser.

The first parametric amplifier may comprise an optical parametric amplifier (OPA). Alternatively, the parametric amplifier may be a fiber-optic parametric amplifier.

The amplified radiation beam may comprise radiation of the first wavelength, radiation of the second wavelength, and optionally radiation of a third wavelength. Radiation of the third wavelength may be referred to as an idler. The third wavelength may be substantially equal to the second wavelength. The amplified radiation beam may further comprise radiation of a fourth wavelength. For example, a fourth wavelength may be created when a fiber-optic parametric amplifier is used.

The second wavelength may be longer than the first wavelength.

The second wavelength may be in the range 1.2 to 5 micron.

The second wavelength may be in the range 2.1 to 2.8 micron. For example, a MWIR laser (e.g. Cr:ZnSe laser) generates radiation at approximately. 2.5 micron and is tunable between 2.2 to 2.8 micron. For example, a SWIR laser e.g. SWIR laser (e.g. Ho:YAG laser) generates radiation at approximately 2.17 micron.

The first laser may comprise a YAG-based laser.

The first wavelength may be approximately 1 micron.

The first wavelength may be approximately 2 micron. For example, the first laser may comprise a big aperture thulium (BAT) laser, generating radiation with a first wavelength of 1.9 micron.

The EUV radiation source may further comprise a delay stage.

The delay stage may be arranged to delay at least a portion of the amplified radiation beam prior to its arrival at the plasma formation region. The source may further comprise a dichroic element arranged to separate a first portion of the amplified radiation beam from a second portion of the amplified radiation beam. The first or second portion may be directed to the delay stage such that the first and second portion arrive at the radiation conversion region at different times. The first and second portion may each comprise a portion of the amplified radiation beam with a particular wavelength, for example the first portion may comprise radiation of the first wavelength. The delay stage may be arranged such that a first portion of the amplified radiation beam may be used as a prepulse and the second portion of the amplified radiation beam may be used as a main pulse.

According to a second aspect of the invention there is provided a lithographic system comprising the EUV radiation source of the first aspect and a lithographic apparatus.

According to a third aspect of the invention there is provided a laser system laser system configured to illuminate a fuel droplet at a plasma formation region of an EUV radiation source, the laser system comprising: a first laser configured to produce radiation of a first wavelength; a second laser configured to produce radiation of a second wavelength; and a parametric amplifier arranged to receive the radiation of the first wavelength and radiation of the second wavelength and generate an amplified radiation beam.

The laser system may further comprise a modulating apparatus configured to provide the radiation of the first and/or second radiation with a box shaped temporal profile.

The laser system may further comprise a beam delivery system arranged to deliver the amplified radiation beam to the plasma formation.

The parametric amplifier may comprise an optical parametric amplifier (OPA).

According to a fourth aspect of the invention there is provided a method of generating EUV radiation comprising: directing radiation of a first wavelength and radiation of a second wavelength to a first parametric amplifier, thereby generating an amplified radiation beam; and illuminating a fuel droplet with the amplified radiation beam.

The fuel droplet may comprise tin. The fuel droplet may be provided at, and illuminated at, a plasma formation region of an EUV radiation source.

The method may further comprise modulating the radiation of the first and/or second wavelength, prior to the first parametric amplifier, such that they have a box shaped temporal profile.

The method may further comprise: directing radiation of the first wavelength and radiation of the second wavelength to a second parametric amplifier, thereby generating an additional amplified radiation beam; and illuminating the fuel droplet with the additional amplified radiation beam.

The method may further comprise generating pulses of radiation of the first wavelength, and directing a first pulse to the first parametric amplifier and a second pulse to the second parametric amplifier.

It will be appreciated that any of the features of above-discussed aspects of the invention may, where appropriate, be combined with one or more other features of the invention.

### BRIEF DESCRIPTION OF THE DRAWINGS

Embodiments of the invention will now be described, by way of example only, with reference to the accompanying schematic drawings, in which:
- Figure 1 schematically depicts a lithographic system comprising a lithographic apparatus and a radiation source and which includes a laser system according to an embodiment of the invention;
- Figure 2 schematically depicts a laser system according to an example implementation of the invention;
- Figure 3 schematically depicts a laser system according to another example implementation of the invention;
- Figure 4 is a pair of graphs which illustrate conversion between wavelengths by the laser systems of the example implementations; and
- Figure 5 schematically depicts a laser system according to another example implementation of the invention.

### DETAILED DESCRIPTION

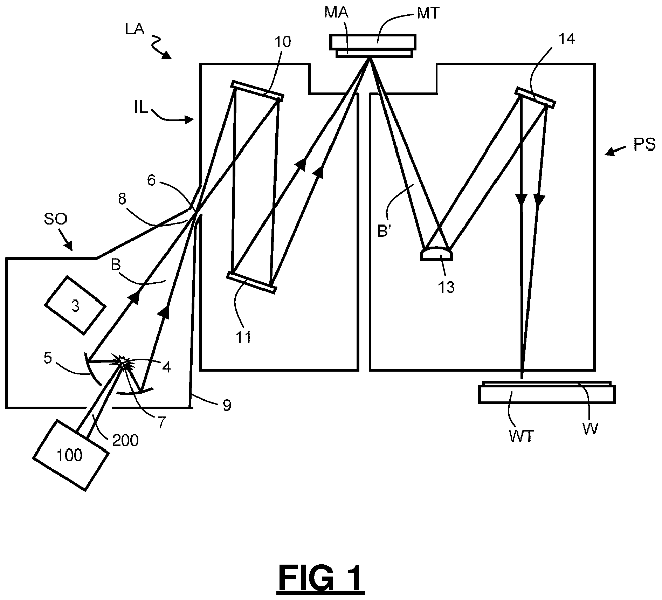

Figure 1 schematically shows a lithographic system which comprises a radiation source SO according to an embodiment of the invention and a lithographic apparatus LA. The radiation source SO is configured to generate an extreme ultraviolet (EUV) radiation beam B. The lithographic apparatus LA comprises an illumination system IL, a support structure MT configured to support a patterning device MA (e.g. a mask), a projection system PS and a substrate table WT configured to support a substrate W. The illumination system IL is configured to condition the radiation beam B before it is incident upon the patterning device MA. The projection system is configured to project the radiation beam B' (now patterned by the mask MA) onto the substrate W. The substrate W may include previously formed patterns. Where this is the case, the lithographic apparatus aligns the patterned radiation beam B' with a pattern previously formed on the substrate W.

The radiation source SO according to an embodiment of the invention, as schematically depicted in Figure 1, is of a type which may be referred to as a laser produced plasma (LPP) source. The radiation source SO comprises a laser system 100 which provides a laser beam 200. The laser beam 200 is incident upon a fuel, such as tin (Sn) which is provided from a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4.

The laser beam 200 may be focused at the plasma formation region 4, for example using focusing optics such as a lens. Alternatively, no focusing optics may be used. For example, it may be advantageous to deliver an unfocused and/or demagnified image at the plasma formation region 4.

The laser beam 200 illuminates (i.e. is incident upon) the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation emitted by the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO. The enclosing structure 9 of the radiation source SO contains the plasma formation region 4, the fuel emitter 3 and the collector 5.

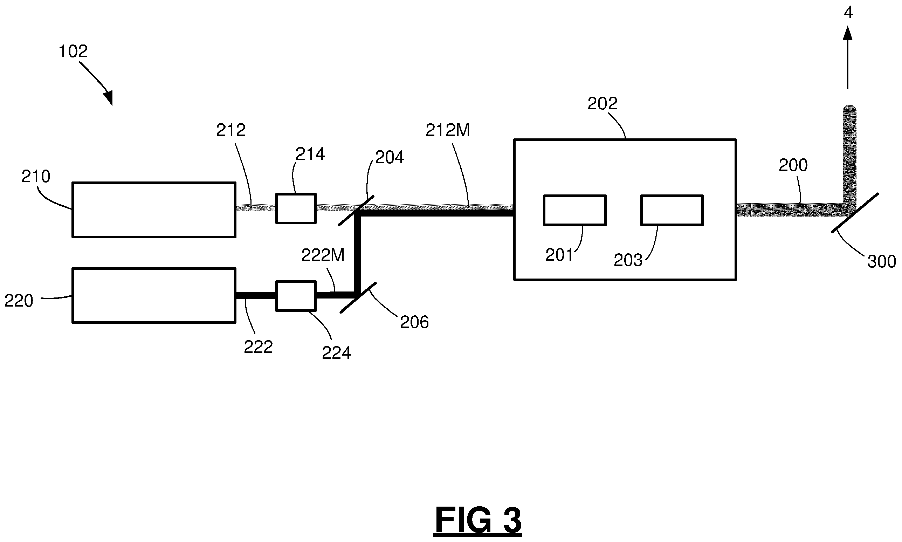

The laser system 100 may be spatially separated from the enclosing structure 9 of the radiation source SO. Where this is the case, the laser beam 200 may be passed from the laser system 100 to the enclosing structure 9 with the aid of a beam delivery system (not shown) comprising, for example, suitable directing mirrors and/or a beam expander, and/or other optics. In particular, the beam delivery system is arranged to deliver the laser beam 200 to the plasma formation region 4. An example beam delivery system 300 is illustrated in Figure 3 which comprises a directing mirror to direct the laser beam 200 to the plasma formation region 4. More than one directing mirror may be provided. Other arrangements of beam delivery system may be used, for example depending on the geometry of the radiation source SO. The beam delivery system may form part of the laser system 100, as depicted in Figure 3, and/or may be located in the radiation source SO separate from the laser system 100. The beam delivery system may comprise a camera or other optical sensors configured to track fuel droplets, and a controller configured to move a directing mirror to ensure that the laser beam 200 is incident on the fuel droplets.

The radiation beam B passes from the radiation source SO into the illumination system IL, which is configured to condition the radiation beam. The illumination system IL may include a facetted field mirror device 10 and a facetted pupil mirror device 11. The faceted field mirror device 10 and faceted pupil mirror device 11 together provide the radiation beam B with a desired cross-sectional shape and a desired angular intensity distribution. The radiation beam B passes from the illumination system IL and is incident upon the patterning device MA held by the support structure MT. The patterning device MA reflects and patterns the radiation beam B. The illumination system IL may include other mirrors or devices in addition to or instead of the faceted field mirror device 10 and faceted pupil mirror device 11.

Following reflection from the patterning device MA the patterned radiation beam B enters the projection system PS. The projection system comprises a plurality of mirrors 13, 14 which are configured to project the radiation beam B onto a substrate W held by the substrate table WT. The projection system PS may apply a reduction factor to the radiation beam, forming an image with features that are smaller than corresponding features on the patterning device MA. A reduction factor of 4 may for example be applied. Although the projection system PS has two mirrors 13, 14 in Figure 1, the projection system may include any number of mirrors (e.g. six mirrors).

The radiation source SO, illumination system IL, and projection system PS may all be constructed and arranged such that they can be isolated from the external environment. A gas at a pressure below atmospheric pressure (e.g. hydrogen) may be provided in the enclosing structure 9 of the radiation source SO. A vacuum may be provided in illumination system IL and/or the projection system PS. A small amount of gas (e.g. hydrogen) at a pressure well below atmospheric pressure may be provided in the illumination system IL and/or the projection system PS.

The radiation source SO shown in Figure 1 may include components which are not illustrated. For example, a spectral filter may be provided in the radiation source. The spectral filter may be substantially transmissive for EUV radiation but substantially blocking for other wavelengths of radiation such as infrared radiation.

The properties of the laser beam 200 generated by the laser system 100 may affect the properties of the EUV radiation emitted from the plasma after fuel is irradiated by the laser beam 200. The EUV radiation emitted from the plasma (i.e. the radiation comprising EUV radiation beam B) has a spectral profile with a range of energies. A small range of energies, also known as a narrow spectral profile, may be desirable in EUV lithography. For example, radiation with a wavelength within 1% of 13.5 nm may be desirable. Radiation at wavelengths other than 13.5 nm, also known as 'out of band' emission, may be ineffective for the desired application. Out of band emission represents a loss of energy. Out of band emission may be removed from the radiation beam B (e.g. using spectral filters). It may be desirable to reduce out of band emission, in particular to increase the conversion efficiency of the LPP process.

Conventional lasers used in a laser system, for example CO₂ lasers, produce a laser beam comprising radiation with a wavelength around 10 micron. Radiation at this wavelength does not penetrate as deeply into the plasma, so produces a small range of EUV photon energies (i.e. a narrow spectral profile). However, radiation at this wavelength experiences reflection from the fuel droplets. For example, when using tin droplets, around 30% of the radiation may be reflected. Reflected radiation implies that energy from the laser beam is not being fully absorbed by the fuel droplets and hence is not being fully converted into EUV radiation. Reflected radiation implies a loss of input power and hence reduced conversion efficiency. Reflection may also damage equipment due to high-energy radiation being directed back to the laser system or other apparatus. It is desirable to reduce reflection of laser radiation from the fuel droplet.

Other lasers which may be used in a laser system, for example some yttrium-aluminum-garnet (YAG) based lasers, can generate radiation with a wavelength around 1 micron. Radiation with a wavelength around 1 micron experiences negligible reflection from common fuel droplets. For example, when using tin droplets, around 0% of the radiation is reflected. However, 1 micron radiation penetrates deeper into the fuel plasma than 10 micron radiation which results in the generation a wide range of EUV energies being produced (i.e. a wide spectral profile with out of band radiation).

Intermediate wavelengths between 1 micron and 10 micron (that is, longer than 1 micron and shorter than 10 micron) form a favorable compromise between reflectivity and generation of out of band radiation. In particular, radiation with a wavelength in the short wavelength infrared (SWIR) to mid wavelength infrared (MWIR) regime, i.e. 1.2 to 5 micron, may be beneficial for both reduced reflectivity and reduced out of band radiation. For example, radiation with an intermediate wavelength of approximately 2 micron may be beneficial. It may be beneficial to match the wavelength to the spacing between the atoms in the fuel droplet at a specific phase or temperature, for example the spacing between tin atoms in a liquid tin droplet.

Known lasers which may generate radiation of such intermediate wavelengths typically produce radiation with low pulse energies. In particular, the pulse energies produced by such lasers may be too low to efficiently generate EUV radiation in an EUV radiation source. For example, a holmium YAG (Ho:YAG) laser can generate radiation with a wavelength of approximately 2 micron, but typically has an average pulse energy in the region of 1 to 10 mJ per pulse. Such pulse energies are typically too low to efficiently generate EUV radiation in an EUV radiation source.

A laser system 100 as described herein may be used to generate radiation with such an intermediate wavelength (e.g., in the range 1.2 to 5 micron), and with a high enough pulse energy for use in an EUV radiation source.

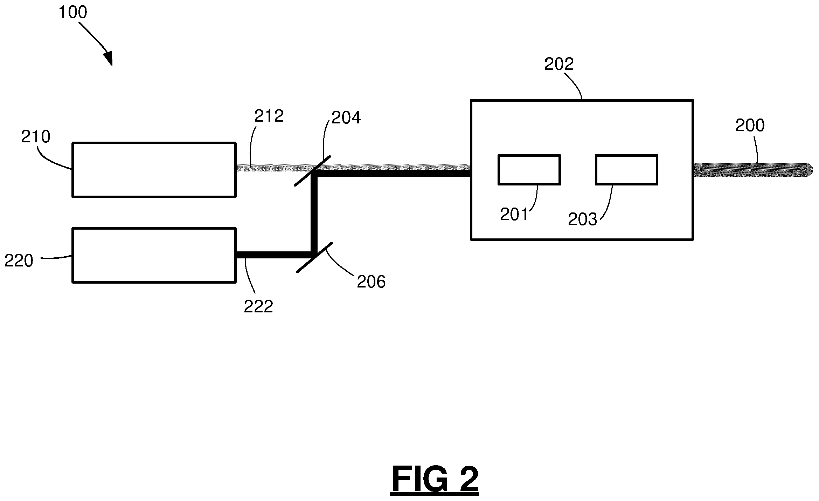

Figure 2 schematically depicts an example laser system 100. The laser system 100 has a first laser 210, a second laser 220, and an optical parametric amplifier (OPA) 202. OPAs are known in the art and are used to amplify a radiation beam, referred to as a seed, when driven by an additional radiation beam, known as a pump. The OPA 202 comprises a first and second nonlinear medium 201, 203. The first and second nonlinear media 201, 203 may comprise, for example crystals comprising potassium titanyl phosphate (KTP). It should be understood that other parametric amplifiers may be used in place of the OPA 202, for example a fiber-based parametric amplifier. In some embodiments a single nonlinear medium may be used.

The first laser 210 is configured to generate radiation of a first wavelength in a first radiation beam 212. The first radiation beam 212 is then directed to the OPA 202 to act as a pump for the OPA 202. The first radiation beam 212 may therefore be referred to as a pump, a pump beam or pump radiation. The second laser 220 is configured to generate radiation of a second wavelength in a second radiation beam 222. The second radiation beam 222 is directed to the OPA 202 such that it can seed the OPA 202. The second radiation beam 222 may therefore be referred to as a seed, a seed beam or seed radiation. The second radiation beam 222 may also be referred to as a signal or signal beam. The first and second wavelengths are different, and the second wavelength is longer than the first wavelength.

Optical components 204, 206 are provided to direct the first radiation beam 212 and second radiation beam 222 to the OPA 202. In particular, a mirror 206 is provided to direct the second radiation beam 222 towards the first radiation beam 212 in free space. A dichroic mirror 204 is provided to direct the second radiation beam 222 to be substantially parallel (e.g. collinear) to the first radiation beam 212. By providing a dichroic mirror 206, the first radiation beam 212 may pass through the dichroic mirror 206 with its optical path unchanged, while the optical path of the second radiation beam 222 is altered by the dichroic mirror 206. It should be understood that different optical components to those depicted may be used, depending on the arrangement of the lasers 210, 220 and OPA 202 and wavelengths used.

By providing the OPA 202 with a pump 212 and a seed 222, it will convert photons in the pump beam 212 (i.e. of the first wavelength) into photons of lower energy. In particular, it will convert photons of the first wavelength into photons of the second wavelength, as well as photons of a third wavelength. This process is known in the art, and radiation of the third wavelength is referred to as an idler, or idler radiation. The third wavelength generally depends on the first and second wavelengths. The relationships between the first, second and third wavelengths are described by standard nonlinear optical theory.

The OPA 202 outputs the converted photons in a laser beam 200. The power of radiation of the second wavelength exiting the OPA 202 in the laser beam 200 is greater than the power of radiation of the second wavelength entering the OPA 202 in the second laser beam 212. That is, the OPA 202 amplifies radiation of the second wavelength. The laser beam 200 comprises radiation of the second wavelength and radiation of the third wavelength, and optionally any radiation of the first wavelength (i.e. the pump) which has not been converted into radiation of the second and third wavelengths. The laser beam 200 from the laser system 100 is then directed to the plasma formation region 4, as described above, where it may illuminate a fuel droplet and thereby generate EUV radiation.

The second laser 220 is selected such that it generates radiation of an intermediate wavelength, for example in the range from 1 to 10 micron, and in particular for example in the range from 1.2 to 5 micron. As such, the OPA 202 will amplify said radiation of the intermediate wavelength, providing a laser beam 200 of a desired wavelength with a pulse energy high enough for use in the generation of EUV radiation.

The first laser 210 may be selected such that it generates radiation with a high pulse energy. By pumping the OPA 202 with radiation with a high pulse energy, a greater degree of amplification may be achieved. The first wavelength may also be selected, with respect to the selected second wavelength, such that the third wavelength is also a desirable wavelength. It may be beneficial, for example, for the third wavelength to be in the intermediate wavelength, for example in the range from 1 to 10 micron, and in particular for example in the range from 1.2 to 5 micron.

The second laser 220 may be selected such that it comprises a solid state laser. For example the second laser 220 may comprise a fiber based laser such as a fiber laser or a fiber pumped laser. A fiber laser has a fiber as an active gain medium. The fiber can be doped, for example with rare-earth elements, which determines the wavelength at which the fiber laser generates radiation. For example, a fiber laser doped with thulium may generate radiation at around 2 micron. A fiber pumped laser is a laser with an active medium of any kind, which is pumped by a fiber laser to achieve lasing. In a fiber pumped laser, the fiber laser may be operated in continuous-wave mode to pump the other laser, thereby generating pulsed radiation. A fiber pumped laser may generate pulsed radiation with high pulse energies, for example 1 mJ per pulse or greater. The doping of the fiber and/or the active gain medium of a fiber pumped laser may be selected so as to select the wavelength of radiation which is generated and/or other properties of the second radiation beam 222. In an example arrangement, it may be beneficial to choose an active medium configured to generate radiation at a similar wavelength to the fiber laser which is pumping it to avoid losses due to heating and/or parasitic lasing. For example, a fiber laser doped with thulium (generating radiation at around 2 micron) may be used to pump another laser which generates radiation at around 2 micron e.g. a holmium YAG laser.

Beneficially, solid-state lasers such as fiber based lasers can generate radiation with a long pulse duration (e.g. up to 100 ns). Additionally, solid-state lasers, particularly fiber based lasers, are generally single mode, and unlikely to experience parasitic generation of higher order modes. As a result, solid state lasers such as fiber based lasers may provide a laser beam 200 that is more easily and/or precisely focused, and therefore able to provide more efficient EUV generation (higher order laser modes are less efficient).

In a particular example arrangement of a laser system 100, the first laser 210 comprises a neodymium-doped YAG (Nd:YAG) laser or a ytterbium-doped YAG (Yb:YAG) laser, both of which generate radiation at a wavelength of around 1 micron when operating at their fundamental wavelength. For example, Nd:YAG lasers emit at a wavelength of about 1.06 micron and Yb:YAG lasers emit at a wavelength of about 1.03 micron. Yb:YAG and Nd:YAG lasers can typically provide said radiation with highly energetic pulses. YAG-based lasers can provide highly energetic pulses (above 1 J/pulse) at high repetition rates (around 50 kHz or more). High repetition rates are desirable because these may provide a higher power of EUV, thereby allowing the lithographic apparatus to have a higher throughput of substrates.

In this particular example arrangement, the second laser 220 comprises a thulium doped fiber laser pumping a holmium YAG (Ho:YAG) laser. A Ho:YAG laser generates radiation with a wavelength of approximately 2.09 micron. That is, the second wavelength is around 2 micron.

YAG-based lasers typically have a high wall-plug efficiency, converting a larger proportion of electrical power to optical power. YAG-based lasers are also have a small footprint (compared to other lasers, for example CO₂ lasers), taking up less floor space which may be beneficial for space and/or transport and/or cost. Furthermore, YAG-based lasers operating at their fundamental wavelength are typically easy to focus as the radiation is substantially in a single mode.

In this particular example arrangement, the pump 212 with a wavelength around 1 micron (the first wavelength) and the seed 222 with a wavelength of around 2 micron (the second wavelength) are provided to the OPA 202. The OPA, pumped by the pump radiation 212, amplifies the seed radiation 222. The OPA 202 also generates radiation of a third wavelength, where the third wavelength is approximately 2.17 micron. That is, the third wavelength is around 2 micron (i.e. equal to the second wavelength), the equivalence being due to a degeneracy in the nonlinear optical processes within the OPA 202. As such, the output of the OPA 202 is a laser beam 200 comprising primarily radiation of 2 micron, which has been amplified in power compared to the power of the seed radiation 222. The laser beam 200 may be referred to as an amplified radiation beam. The laser beam 200 may also comprise some radiation with a wavelength of 1 micron, due to any unconverted pump radiation 212 still present. OPA conversion efficiencies (defined as the amount of power in the output laser beam 200 compared to the combined power contained in the pump 212 and seed 222) of in excess of 60% can be achieved using this example arrangement. That is, a high power laser beam 200 comprising radiation of an intermediate wavelength (in particular, 2 micron) may be generated.

A conversion efficiency of the OPA 202 can be calculated as the ratio between the power provided to the OPA 202 (the combined power of the pump beam 212 and the seed beam 222) and the power output by the OPA 202 (in the laser beam 200). A conversion efficiency of the radiation source SO can be calculated as the ratio between the power provided to the plasma formation region 4 (in the laser beam 200) and the power of EUV radiation generated at the plasma formation region 4. As noted further above, the laser beam 200 may provide a higher conversion efficiency from laser power to EUV radiation power of than conventionally used wavelengths.

Properties of the radiation generated by the first laser 210 and second laser 220 may be selected to increase the conversion efficiency of the OPA 202. Properties of the radiation generated by the first laser 210 and second laser 220 may be selected to optimize the properties of the laser beam 200 so as to increase the conversion efficiency of the radiation source SO. Such properties include the wavelength, repetition rate, pulse duration, peak and/or average pulse energy, peak and/or average intensity, and temporal pulse shape.

The laser beam 200 may beneficially be selected to have a peak intensity in the range from 1 x 10¹⁰ W/cm² to 1.5 x 10¹¹ W/cm² so as to increase the conversion efficiency of the radiation source SO. The higher end of the range of peak intensities may be particularly desirable when using a second wavelength in the range 1 to 5 micron. In order to achieve such peak intensities, the peak intensities of the first radiation beam 212 and second radiation beam 222 and the conversion efficiency of the OPA 202 may be selected accordingly.

The laser beam 200 may beneficially be selected to have a pulse energy in the range from 300 mJ to 3 J so as to increase the conversion efficiency of the radiation source SO. The higher end of the range of pulse energies may be particularly desirable when using a second wavelength in the range 1 to 5 micron. In order to achieve such pulse energies, the pulse energies (or average power) of the first radiation beam 212 and second radiation beam 222 and the conversion efficiency of the OPA 202 may be selected accordingly.

A high repetition rate (e.g. in the range from 1 kHz to 100 kHz or more) and/or a long pulse duration (e.g. in the range from 1 ns to 100 ns or more, in particular over 10 ns) may be desirable for the first radiation beam 212, second radiation beam 222 and laser beam 200. A long pulse duration may be preferable so as to increase the conversion efficiency of the radiation source and/or the power of EUV radiation provided by the radiation source. A long pulse duration may, for example, increase the energy imparted by the laser beam 200 to the fuel droplets due to the increased time during which the fuel droplet is illuminated.

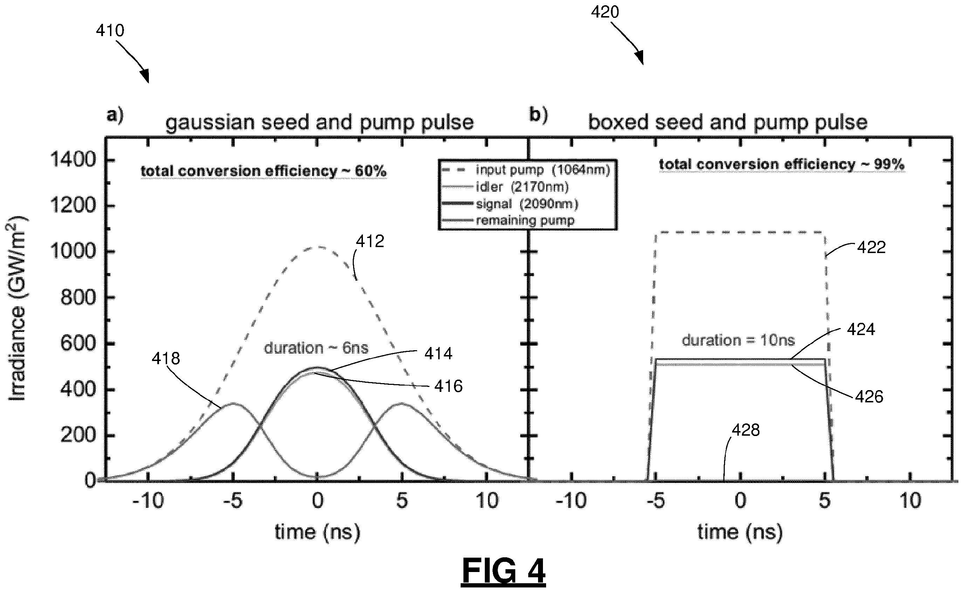

Furthermore, lasers typically generate radiation with a temporal pulse shape which is Gaussian. However, it may be beneficial to alter the temporal pulse shape of the first and/or second laser beam 212, 222 as described below and with reference to Figures 3 and 4. The temporal pulse shape may alternatively be referred to as a temporal profile.

Figure 3 schematically depicts another example arrangement of a laser system 102. The laser system 102 in Figure 3 is similar to the laser system 100 depicted in Figure 2, and like parts are labelled accordingly. For simplicity, the laser system 100 depicted in Figure 2 will herein be referred to as a first laser system 100 and the laser system 102 depicted in Figure 3 will herein be referred to as a second laser system 102.

The second laser system 102 is configured to alter the temporal pulse shape of the first and second laser beams 212, 222. The second laser system 102 comprises a first acousto-optic modulator (AOM) 214 and a second AOM 224. The first and second AOM 214, 224 are arranged in the optical paths of the first and second radiation beams 212, 222, respectively. The first AOM 214 is configured to receive the first radiation beam 212 and output a first modulated radiation beam 212M. In particular, the first AOM 214 modulates pulses of radiation in the first radiation beam 212 to alter their temporal profile from a Gaussian shape to a box shape. A box shaped temporal profile may also be referred to as a top hat profile. The first modulated radiation beam 212M hence comprises pulses of radiation with a box shaped temporal profile. The first modulated radiation beam 212M is then delivered to the OPA 202. Correspondingly, the second AOM 224 modulates pulses of radiation in the second radiation beam 222 and outputs a second modulated radiation beam 222M comprising pulses of radiation with a box shaped temporal profile (or top hat profile). The second modulated radiation beam 222M is then delivered to the OPA 202. As such, the OPA 202 in the second laser system 102 receives pulses of radiation with a box shaped temporal profile in both the pump beam 212 and the seed beam 222.

In the specific example described with reference to Figure 3, AOMs are used to generate box shaped temporal profiles. However, those skilled in the art will understand that other modulating apparatus for modulating temporal profiles are available. An electro-optic modulator (EOM) may additionally or alternatively be used to generate box shaped temporal profiles. An apparatus for modulating temporal profiles may be referred to as a profile modulating apparatus. Such a profile modulating apparatus may comprise part of the lasers 210, 220 themselves. For example, a distributed feedback structure may be used in the laser gain medium to shape the temporal profile. Alternatively, if the first or second laser 210, 220 are seeded (for example comprising a fiber pumped laser), the seed laser may be shaped with a box shaped profile (e.g. using a profile modulating apparatus such as an EOM) prior to pumping the active gain medium. Alternatively, the profile modulating apparatus may comprise a separate module in the laser system 102, for example an EOM or AOM (which may for example be located after the lasers 210, 220).

Beneficially, using pulses with a box shaped temporal profile increases the conversion efficiency of the OPA 202. This is demonstrated below with example arrangements of the first and second laser systems 100, 102, using example lasers as follows

The first laser 210 in the first and second laser systems 100, 102 comprises a neodymium YAG (Nd:YAG) laser. The first laser 210 generates a pump beam 212 with a first wavelength of 1064 nm (i.e. around 1 micron), with a pulse duration of 10 ns and a pulse energy of 1 J/pulse. The pulses of radiation generated by the first laser 210 have a temporal profile which is Gaussian. In the first and second laser systems 100, 102, the second laser 220 comprises a holmium YAG (Ho:YAG) laser. The second laser 220 generates a seed beam 222 with a second wavelength of 2090 nm (i.e. around 2 micron), with a pulse duration of 10 ns and a pulse energy of 5 mJ/pulse. In both arrangements, the OPA 202 comprises two KTP crystals with a total length of 4 cm.

In both arrangements, the pump beam 212 and seed beam 222 are directed to the OPA 202. In both arrangements, the OPA 202 generates idler radiation with a wavelength of 2170 nm (i.e. around 2 micron). As such, the OPA 202 outputs a laser beam 200 comprising primarily radiation with a wavelength of around 2 micron. In particular, the output laser beam comprises radiation with a signal wavelength of 2090 nm and radiation with an idler wavelength of 2170 nm. That is, the output laser beam 200 comprises a portion of output signal and output idler. The output laser beam 200 also comprises radiation with a wavelength of around 1 micron, due to unconverted radiation from the pump 212. Radiation of the first wavelength (around 1 micron) in the output laser beam 200 may be referred to as a remaining pump.

Figure 4 illustrates the conversion efficiency of the OPA 202 for the first and second laser systems 100, 102. A first graph 410 depicts the irradiance of radiation beams in the first laser system 100, with respect to time. In particular, the first graph 410 depicts the irradiances of the input pump beam 412 (with a wavelength of 1064 nm), the irradiance of the output signal beam 414 (with a wavelength of 2090 nm), the irradiance of the output idler beam 416 (with a wavelength of 2170 nm) and the irradiance of the remaining pump 418 (with a wavelength of 1064 nm). The temporal profiles of the input beam 412 and output signal and idler beams 414, 416 in the first graph 410 are Gaussian in shape. However, the temporal pulse duration of the output signal and output idler are shortened compared to the input pump pulse, from 10 ns to 6 ns.

A second graph 420 depicts the irradiance of radiation beams in the second laser system 102, with respect to time. In particular, the second graph 420 depicts the irradiances of the input pump beam 422 (with a wavelength of 1064 nm), the irradiance of the output signal beam 424 (with a wavelength of 2090 nm) and the irradiance of the output idler beam 426 (with a wavelength of 2170 nm). Also depicted in the second graph 420 is the irradiance of the remaining pump 428 (with a wavelength of 1064 nm), although the magnitude is minimal and is hence not visible above the axis. The temporal duration of the output signal and output idler are comparable to the input pump i.e. 10 ns in duration.

It can be seen in the first graph 410, corresponding to the first laser system 100 with Gaussian-shaped temporal profiles, that a substantial amount of pump radiation remains in the laser beam. That is, a substantial amount of pump radiation is unconverted. The conversion efficiency of the OPA 202 in the first laser system 100 is approximately 60%.

It can be seen in the second graph 420, corresponding to the second laser system 102 with box shaped temporal profiles, that a negligible amount of pump radiation remains in the laser beam. The conversion efficiency of the OPA 202 in the second laser system 102 is approximately 99%. As such, in this example second laser system, radiation in the pump beam with an energy of 1 J/pulse is substantially all converted into signal radiation and idler radiation. The output laser beam 200 generated by the OPA comprises radiation with a wavelength of 2090 nm with an energy of approximately 500 mJ/pulse, and radiation with a wavelength of 2190 nm with an energy of approximately 500 mJ/pulse. That is the output laser beam 200 generated by the OPA comprises radiation with a wavelength of approximately 2 micron with an energy of approximately 1 J/pulse. By further increasing the energy per pulse of pump radiation, the total energy per pulse of the output laser beam 200 may be further increased.

The pulse duration may also be increased using an arrangement such as the second laser system 102 described herein, for example pulse durations up to hundreds of ns may be achieved. The conversion efficiency of the OPA 202 may be increased by increasing the temporal duration of the overlap of the pump pulse and the probe pulse. Long pulse durations may be achieved with relative ease using solid state lasers, for example fiber based lasers. Long pulse durations may be achieved using YAG-based lasers, for example a Nd:YAG laser, by providing longer and/or additional YAG crystals in the laser.

Beneficially, a laser system 100, 102 as described herein may be used to generate a laser beam 200 with intermediate wavelength and properties suitable for the efficient generation of EUV radiation.

Furthermore, such a laser beam 200 may be generated with a high repetition rate, for example 1 kHz or more, 10 KHz or more, or 100 kHz or more. The repetition rate may be increased, for example by cooling elements of the OPA so as to prevent or reduce the damage experienced by the OPA thereby increasing the achievable repetition rate. Alternatively or additionally, multiple OPAs may be used so as to share the load between different components, thereby reducing avoiding or reducing damage and increasing the achievable repetition rate.

It should be noted that, while running a high repetition rate seed laser 220 is power consumptive compared to a lower repetition rate, the power consumption is significantly less than running a high repetition rate pump laser 210. As such, a laser system 100, 102 as described herein may operate with a greatly increased wall plug efficiency compared to known laser systems comprising, for example, a CO₂ laser.

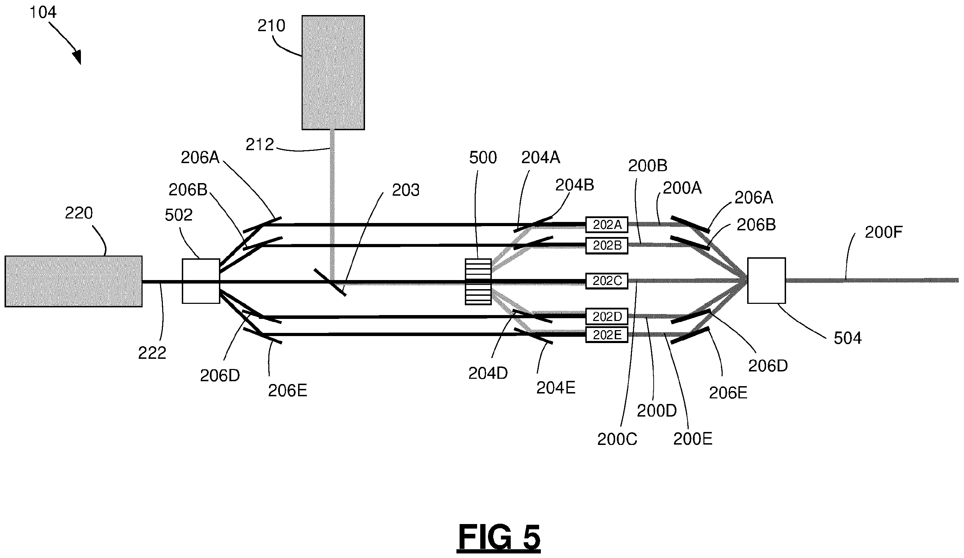

Figure 5 schematically depicts another example arrangement of a laser system 104. The laser system 104 in Figure 5 is similar to the laser systems 100, 102 depicted in Figures 2 and 3, and like parts are labelled accordingly. For simplicity, the laser system 104 depicted in Figure 5 will herein be referred to as a third laser system 104.

The third laser system 104 comprises a first laser 210 configured to generate radiation of a first wavelength in a first radiation beam 212, which may also be referred to as a pump, pump beam, or pump radiation. The third laser system 104 also comprises a second laser 220 configured to generate radiation of a second wavelength in a second radiation beam 222, which may also be referred to as a seed, seed beam, or seed radiation. The third laser system 104 also comprises a plurality of OPAs 202A, 202B, 202C, 202D, 202E. In particular, the laser system 104 comprises five OPAs 202A, 202B, 202C, 202D, 202E, but in other example arrangements another number of OPAs may be used, for example two or six or more. Rather than an OPA, another type of parametric amplifier may be used, for example a fiber-based parametric amplifier.

The third laser system 104 comprises a beam distribution apparatus configured to deliver a portion of the first radiation beam 212 and a portion of the second radiation beam 222 to each OPA 202A, 202B, 202C, 202D, 202E. Each OPA 202A, 202B, 202C, 202D, 202E generates its own amplified radiation beam 200A, 200B, 200C, 200D, 200E in a manner as discussed above with reference to the first and second laser systems 100, 102. That is, compared to the first and second laser systems 100, 102, the third laser system 104 generates an amplified radiation beam 200A and four additional amplified radiation beams 200B, 200C, 200D, 200E.

Each amplified radiation beam 200A, 200B, 200C, 200D, 200E is then delivered to the plasma formation region 4 where they may illuminate a fuel droplet and thereby generate EUV radiation. In particular, the third laser system 104 comprises a beam combining system 504 which combines each amplified radiation beam 200A, 200B, 200C, 200D, 200E into a single laser beam 200F which may be delivered to the plasma formation region 4. The beam combining system 504 may comprise a portion of the beam delivery system 300 described above, or it may be a separate module. The beam combining system 504 may comprise components configured to collimate the amplified radiation beams 200A, 200B, 200C, 200D, 200E, for example, a prism, a collimating lens, a holographic lens, a modulating apparatus such as an acousto-optic modulator or electro-optic modulator, Alternatively, the amplified radiation beams 200A, 200B, 200C, 200D, 200E may be directed along separate beam paths to the plasma formation region 4.

The beam distribution apparatus configured to deliver a portion of the first radiation beam 212 to each OPA 202A, 202B, 202C, 202D, 202E comprises a pulse modulating apparatus 500. In particular, the pulse modulating apparatus 500 may comprise an AOM or EOM. Such an AOM or EOM may utilize the high frequency at which they can change diffractive power to direct different pulses along different optical paths. The pulse modulating apparatus 500 is configured to deliver a first pulse of radiation in the pump beam 212 to the first OPA 202A, a second pulse of radiation in the pump beam 212 to the second OPA 202B, a third pulse of radiation in the pump beam 212 to the third OPA 202C, a fourth pulse of radiation in the pump beam 212 to the fourth OPA 202D, and a fifth pulse of radiation in the pump beam 212 to the fifth OPA 202E. That is, the pulse modulating apparatus 500 directs the delivery of pulsed radiation to multiple OPAs 202A, 202B, 202C, 202D, 202E (pulses are distributed to multiple targets). As such, each OPA 202A, 202B, 202C, 202D, 202E receives only a portion of the total average power of the pump beam 212. As a result, the chance of laser induced damage in each OPA 202A, 202B, 202C, 202D 202E, for example due to thermal stresses in the nonlinear medium is lower. By reducing the thermal stress on each OPA 202A, 202B, 202C, 202D, 202E, the repetition rate and/or peak pulse energy and/or pulse duration of pulses in the pump beam 212 may be increased without risking damage to or saturation of the OPAs 202A, 202B, 202C, 202D, 202E. As such, a greater total power of amplified radiation may be generated compared to using only one OPA. That is, even though the pulses in the pump beam 212 are being split between multiple OPAs 202A, 202B, 202C, 202D, 202E, the total combined power within the amplified radiation beams 200A, 200B, 200C, 200D, 200E is generally greater than the total power of an amplified radiation beam generated using the same pump beam 212 pumping a single OPA. The third laser system 104, or a laser system arranged using these principles, provides a method of scaling up the power of the laser beam 200, 200F to higher powers.

The beam distribution apparatus configured to deliver a portion of the second radiation beam 222 to each OPA 202A, 202B, 202C, 202D, 202E comprises a beamsplitting apparatus 502. The beamsplitting apparatus 502 directs a portion of the total energy of the seed beam 222 along different optical paths towards each OPA 202A, 202B, 202C, 202D, 202E, without affecting the pulse rate received by each OPA 202A, 202B, 202C, 202D, 202E. In this arrangement, the peak power of each pulse is reduced but all pulses are received by all OPAs 202A, 202B, 202C, 202D, 202E. Alternatively, a pulse modulating apparatus may be used such that different pulses in the seed beam 222 are directed to different OPAs 202A, 202B, 202C, 202D, 202E. In this alternative arrangement, the peak energy of each pulse is not reduced. A pulse modulating apparatus may be referred to as an active optical element, whereas a beamsplitting apparatus 502 may typically be a passive optical element (e.g. a grating).

The third laser system 104 as illustrated also comprises additional optical components arranged to deliver radiation within the laser system 104. For example, a dichroic mirror 203 is provided so as to redirect the pump beam 212 to the pulse modulating apparatus 500 while permitting passage of the seed beam 222 (or a portion thereof). Additional dichroic mirrors 204A, 204B, 204D, 204E (i.e. a set of dichroic mirrors) are provided to direct pulses of radiation from the pulse beam 212 which have been redirected by the pulse modulating apparatus 500 to their respective OPAs 202A, 202B, 202D, 202E. The set of dichroic mirrors 204A, 204B, 204D, 204E are arranged to direct pulses of the pump beam 212 while permitting passage of the seed beam 222 (or portions thereof). A first set of additional mirrors 206A, 206B, 206D, 206E is arranged to direct portions of the seed beam which have been redirected by the beamsplitting apparatus 502 to their respective OPAs 202A, 202B, 202D, 202E. A second set of additional mirrors 206B are arranged to direct the amplified radiation beams 200A, 200B, 200D, 200E to the beam combining system 504.

It should be understood that different optical components to those depicted may be used, depending on the arrangement of the lasers 210, 220, OPAs 202A, 202B, 202C, 202D, 202E, pulse modulating apparatus 500, beamsplitting apparatus 502, beam combining apparatus 503 and wavelengths used. For example, in the illustrated arrangement, no dichroic mirror has been provided to direct pulses of pump radiation from the pulse modulating apparatus 500 to the third OPA 202C as, in the illustrated arrangement, the radiation is travelling along the main optical axis. In a different arrangement, another dichroic mirror e.g. 204C may be used. Different numbers of optical components may be used, for example more optical components may be required if more OPAs are used.

In the first, second and third laser systems 100, 102, 104, after the amplified radiation beam 200, 200A, 200B, 200C, 200D, 200E, 200F has been output from the OPA 202, 202A, 202B, 202C, 202D, 202E, 200F, the laser beam 200, 200A, 200B, 200C, 200D, 200E, 200F may be processed and/or modulated further. Such processing and/or modulating apparatus may be provided in a separate module either in the laser system 100, 102, 104 or between the laser system and the plasma formation region 4. Such a processing and/or modulating apparatus may, for example, comprise part of the beam delivery system 300. When using multiple parametric amplifiers, for example in the third laser system 104, a processing and/or modulating process may be performed on the amplified beams 200A, 200B, 200C, 200D, 200E prior to the beam combining apparatus 504 and/or may be performed on the combined laser beam 200F.

For example, radiation of the first, second and/or third wavelengths may be removed from the laser beam 200, for example using a band-pass filter and/or dichroic mirror. In a particular example, remaining pump radiation (with the first wavelength) may be removed from the laser beam 200. In this case, only radiation of the second wavelength and third wavelength is directed to the plasma formation region and subsequently used to form EUV radiation. However, in some situations illuminating fuel droplets with radiation of the first, second and third wavelengths may be beneficial because it utilizes all available radiation to illuminate fuel droplets. That is, no optical power is wasted or removed from the system unnecessarily.

To enable the use of multiple wavelengths of radiation to illuminate fuel droplets, corrective optics may be required to correctly deliver radiation of multiple wavelengths at the plasma formation region 4. The corrective optics used for this may include, but are not limited to, dichroic mirrors and/or achromats.

Remaining pump radiation be recovered, for example by separating it from the laser beam 200 using a dichroic mirror and redirecting it back into the OPA to produce more radiation of the second and third wavelengths.

Some known lithography methods use two pulses of radiation to illuminate the fuel droplets. These two pulses may be referred to as a pre-pulse and a main pulse respectively. The pre-pulse heats the fuel. In some cases the pre-pulse turns the fuel into a low density plasma. The pre-pulse may also shape the fuel, which may be referred to as modifying the fuel distribution. The main pulse may then be incident on the modified fuel distribution. The main pulse creates the highly ionized plasma which emits EUV radiation. Two pulse illumination may be used in combination with the above examples, for example providing a pre-pulse from an additional radiation source and using the radiation beam 200 as the main pulse.

In another example implementation, the laser beam 200 may be separated into a first and second portion, and the first portion used as a pre-pulse and the second portion used as the main pulse. The laser beam 200 may be separated using a beam splitter. The beam splitter may be a dichroic mirror configured to reflect radiation of the first and/or second and/or third wavelength. Alternatively the beam splitter may be a partially transmissive mirror, for example a half-silvered mirror, arranged to separate a first portion of the laser beam 200, for example 50% of the beam, from a second portion of the beam. An optical delay arrangement may be used to temporally separate the first and second portion of the laser beam 200. Such an optical delay arrangement may be referred to as a delay line or a delay stage. The delay stage may comprise a portion of the beam delivery system 300. Known delay stages are described in more detail in US7326948, which is hereby incorporated by reference in its entirety. In brief, the delay stage may be in the form of a plurality of mirrors to add distance to the path travelled by a portion of a beam.

In some implementations, using an intermediate wavelength as proposed may provide efficient EUV generation without requiring the use of a pre-pulse and a main pulse.

Specific examples of lasers providing specific first, second, and third wavelengths have been described above. However, it should be understood that the wavelengths may be selected as required by the user.

For example, the second and third wavelengths can be selected by changing the OPA 202. The nonlinear medium within the OPA may be a nonlinear crystal, for example potassium titanyle arsenate (KTA), potassium titanyl phosphate (KTP), barium borate (BBO) or lithium niobate (LN), periodically poled KTP (PPKPT), periodically poled LN (PPLN), rubidium doped KTP (RKTP), periodically poled rubidium doped KTP (PPRKTP), zinc germanium phosphide (ZGP), or periodically poled ZGP. Periodically poled crystals may beneficially increase the conversion efficiency of the OPA 202 and/or reduce the required pulse energy of the seed 222. This list is non-exhaustive and there are many other nonlinear crystals known in the art which may be used depending on the requirements of the user. Two or more nonlinear crystals may be used. The two or more nonlinear crystals may comprise the same nonlinear material or different nonlinear materials, for example a combination of a PPLN crystal and a KTP crystal.

Alternatively or in addition, the second and third wavelengths can be selected by altering the phase matching properties of the nonlinear crystal. Altering the phase matching properties of the nonlinear crystal allows for tunable selection of the second and third wavelengths. The wavelengths may be tunable within a range, where the range may be dependent on factors such as the pump wavelength, pump polarization, and the nonlinear crystal material. The phase matching properties of the nonlinear crystal, and hence the second and third wavelengths, can be selected in a number of ways. For example, the temperature of the nonlinear crystal may be altered. Altering the temperature may be particularly advantageous for tuning the second and third wavelengths when using periodically poled nonlinear media. Alternatively or in addition, the length of the optical cavity in the OPA may be altered. Alternatively or in addition, a dispersive element such as a grating may be provided. Alternatively or in addition, the angular orientation of the nonlinear crystal may be altered with respect the radiation beam, for example by altering the orientation of the optical axis of the crystal and/or the polarization of the radiation beam.

Specific reference has been made to Ho:YAG lasers as the seed laser, which typically generates radiation at 2.17 micron. However, other lasers may be used as a seed laser. That is, other lasers generate radiation of an intermediate wavelength. For example, a Cr:ZnSe laser generates radiation at approximately 2.5 micron and is tunable between 2.2 to 2.8 micron. Using these lasers, a range of second wavelengths may be achieved between 2.1 and 2.8 micron. That is, using these lasers a range of second wavelengths may be achieved between around 2 micron and around 3 micron.

Specific reference has been made herein to the conversion of radiation by the parametric amplifier. It may also be said that the parametric amplifier 'generates' radiation (e.g. generates an amplified radiation beam). The 'generation' of radiation by the parametric amplifier should be understood to be due to the conversion of radiation of the first wavelength into radiation of the second and third wavelengths. It may also be said that the parametric amplifier amplifies radiation, in that it amplifies radiation of a second (seed) wavelength (and radiation of a third (idler) wavelength) when pumped by radiation of a first (pump) wavelength. These descriptive terms should be construed as equivalent and the descriptive terms themselves are known in the art,

Although specific reference may be made in this text to mirrors, any suitable optical elements may be used. For example, the element may be a grating, a beam cube or any other dispersive element. In some cases the mirrors may be beamsplitting, for example a dichroic mirror, a half-silvered mirror, or any other beam splitting element known in the art.

Although specific reference may be made to YAG-based lasers, any suitable lasers may be used. In this instance, any suitable laser may be one that emits at a wavelength that enables production of a second wavelength in the range 1 to 10 micron, and in particular for example 1.2 to 5 micron. For example, a big aperture thulium (BAT) laser, emitting at 1.9 micron, in combination with a seed laser emitting at 4 micron and a ZGP crystal in an OPA 202 may generate radiation of a second wavelength of 4 micron or longer.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An EUV radiation source comprising:
a fuel emitter configured to produce fuel droplets;
a laser system configured to illuminate a fuel droplet at a plasma formation region, the laser system comprising:
a first laser configured to produce radiation of a first wavelength in a first radiation beam;
a second laser configured to produce radiation of a second wavelength in a second radiation beam; and
a first parametric amplifier arranged to receive the radiation of the first wavelength and radiation of the second wavelength and generate an amplified radiation beam; and
a beam delivery system configured to deliver the amplified radiation beam to the plasma formation region.

2. The EUV radiation source of claim 1, further comprising a profile modulating apparatus configured to provide the radiation of the first and/or second wavelength with a box shaped temporal profile.

3. The EUV radiation source of claim 2, wherein the profile modulating apparatus is an acousto-optic modulator (AOM) or an electro-optic modulator (EOM).

4. The EUV radiation source of claim 2, wherein the first and/or second laser comprise the profile modulating apparatus.

5. The EUV radiation source of any preceding claim, the laser system further comprising:
a second parametric amplifier arranged to receive radiation of the first wavelength and radiation of the second wavelength and generate an additional amplified radiation beam, and wherein the beam delivery system is configured to deliver the additional amplified radiation beam to the plasma formation.

6. The EUV radiation source of claim 5, wherein the first radiation beam comprises pulsed radiation, the laser system further comprising:
a pulse modulating apparatus configured to receive the pulsed radiation and direct a first pulse to the first parametric amplifier and a second pulse to the second parametric amplifier; and
a beamsplitting apparatus configured to receive the second radiation beam and direct a first portion of the second radiation beam to the first parametric amplifier and a second portion of the second radiation beam to the second parametric amplifier.

7. The EUV radiation source of any preceding claim, wherein the second laser comprises a solid state laser.

8. The EUV radiation source of any preceding claim wherein the first parametric amplifier comprises an optical parametric amplifier (OPA).

9. The EUV radiation source of any preceding claim, wherein the amplified radiation beam comprises radiation of the first wavelength, radiation of the second wavelength, and optionally radiation of a third wavelength.

10. The EUV radiation source of any preceding claim, wherein the second wavelength is longer than the first wavelength.

11. The EUV radiation source of any preceding claim, wherein the second wavelength is in the range 1.2 to 5 micron.

12. The EUV radiation source of any preceding claim, wherein the second wavelength is in the range 2.1 to 2.8 micron.

13. The EUV radiation source of any preceding claim, wherein the first laser comprises a YAG-based laser.

14. The EUV radiation source of any preceding claim, wherein the first wavelength is approximately 1 micron.

15. The EUV radiation source of any of claims 1 to 13, wherein the first wavelength is approximately 2 micron.

16. The EUV radiation source of any preceding claim, further comprising a delay stage.

17. A lithographic system comprising the EUV radiation source of any preceding claim and a lithographic apparatus.

18. A laser system laser system configured to illuminate a fuel droplet at a plasma formation region of an EUV radiation source, the laser system comprising:
a first laser configured to produce radiation of a first wavelength;
a second laser configured to produce radiation of a second wavelength; and
a parametric amplifier arranged to receive the radiation of the first wavelength and radiation of the second wavelength and generate an amplified radiation beam.

19. The laser system of claim 18, further comprising a modulating apparatus configured to provide the radiation of the first and/or second radiation with a box shaped temporal profile.

20. The laser system of claim 18 or 19, further comprising a beam delivery system arranged to deliver the amplified radiation beam to the plasma formation.

21. The laser system of any of claims 18 to 20, wherein the parametric amplifier comprises an optical parametric amplifier (OPA).

22. A method of generating EUV radiation comprising:
directing radiation of a first wavelength and radiation of a second wavelength to a first parametric amplifier, thereby generating an amplified radiation beam; and
illuminating a fuel droplet with the amplified radiation beam.

23. The method of claim 22 further comprising modulating the radiation of the first and/or second wavelength, prior to the first parametric amplifier, such that they have a box shaped temporal profile.

24. The method of claim 22 or 23, further comprising:
directing radiation of the first wavelength and radiation of the second wavelength to a second parametric amplifier, thereby generating an additional amplified radiation beam; and
illuminating the fuel droplet with the additional amplified radiation beam.

25. The method of claim 24, further comprising generating pulses of radiation of the first wavelength, and directing a first pulse to the first parametric amplifier and a second pulse to the second parametric amplifier.
